# EUROPÄISCHE PATENTSCHRIFT

(11) **EP 0 938 133 B1**
(45) Veröffentlichungstag und Bekanntmachung des Hinweises auf die Patenterteilung: **12.09.2001**
(21) Anmeldenummer: 99101974.6
(22) Anmeldetag: 01.02.1999
(51) Int. Cl.: H01L 21/306

(54) **Verfahren zum Rauhätzen einer Halbleiter-Oberfläche**
Etching process for forming a rough surface of a semiconductor
Procédé d'attaque pour former une surface de semiconducteur rugueuse

(30) Priorität: 17.02.1998 DE 19806406
(43) Veröffentlichungstag der Anmeldung: 25.08.1999
(73) Patentinhaber: SEZ Semiconductor-Equipment Zubehör für die Halbleiterfertigung AG, 9500 Villach (AT)
(72) Erfinder: Kovacs, Frederic, 9500 Villach(Kärnten) (AT); Kruwinus, Hans-Jürgen Dipl.-Ing., 9551 Bodensdorf (Kärnten) (AT)

(56) Entgegenhaltungen:
- EP-A- 0 019 468
- EP-A- 0 344 764
- EP-A- 0 718 873
- EP-A- 0 791 953
- PATENT ABSTRACTS OF JAPAN vol. 013, no. 383 (E-811), 24. August 1989 (1989-08-24) & JP 01 133324 A (FUJITSU LTD), 25. Mai 1989 (1989-05-25)

## Beschreibung

Die Erfindung betrifft ein Verfahren zum Rauhätzen einer Halbleiter-Oberfläche.

Halbleiter, beispielsweise in Form sogenannter Wafer (kreisförmige Halbleiterscheiben auf Siliziumbasis) erfordern grundsätzlich eine besondere Sorgfalt bei der Herstellung. Hierzu gehört auch eine definierte Rauhigkeit ihrer Oberfläche (n) .

Wie sich aus der EP 0 791 953 A2 ergibt können die Wafer dabei zunächst auf beiden Seiten (Oberflächen) poliert werden. Vorder- und Rückseite sind dann nicht mehr unterscheidbar. Dies gilt auch unter Einsatz von optischen Sensoren, jedenfalls solange beide Oberflächen eine gleiche "Oberflächenstruktur" haben.

Bevor die Wafer-Oberfläche mit verschiedenen Schichten, zum Beispiel aus Gold, Titan, Kupfer oder Polysilizium, belegt wird muß die entsprechende Oberfläche gereinigt und aufgerauht werden. Angestrebt wir eine definierte, über die Halbleiter-Oberfläche konstante Rauhigkeit.

Die EP 0 344 764 A2 beschreibt ein Verfahren zur naßchemischen Oberflächenbehandlung von Halbleiterscheiben bei dem Gase in Wasser gelöst werden und zwar unmittelbar in dem System in dem die Halbleiterscheiben behandelt werden. In zeitlicher Abfolge können so wässrige Lösungen verschiedener Gase auf die Oberfläche einwirken. Hier wird ausschließlich ein Reinigungsverfahren beschrieben.

Die EP 0 791 953 A2 schlägt im Zusammenhang mit Rauhigkeit vor, eine Wafer-Oberfläche mit Hilfe einer Säuremischung zu ätzen und die andere Oberfläche erneut zu polieren.

Die Ätzzeit wird bei einem Wafer mit 150 mm Durchmesser mit 1 bis 3 Minuten angegeben. Während des Ätzvorgangs wird der Halbleiter, (Wafer) mit 10 bis, 100 Umdrehungen pro Minute gedreht. Die Ätzmittelmenge ist mit 2-3 Liter/min angegeben. Die Rauhigkeit der behandelten Oberfläche wurde von Ra = 0,01 µm auf Ra = 0,5 bis 1,0 µm (DIN 4766 T1) nach dem Ätzen erhöht (entsprechend einer Rauhigkeit von 5.000 bis 10.000 Angström).

Auch bei diesem Verfahren bleibt, insbesondere bei hoch dotierten Wafern, der Nachteil einer ungleichmäßigen Ätzbehandlung. Die Oberfläche ist nach dem Ätzen ungleichmäßig und meist nicht reproduzierbar. Verdünnte Ätzflüssigkeiten reichen nicht aus, die gewünschte Rauhigkeit zu erreichen.

Völlig überraschend wurde nun festgestellt, daß sich Wafer mit konstanter, reproduzierbarer Oberflächen-Rauhigkeit unter Anwendung eines Rotations-Ätzverfahrens dann herstellen lassen, wenn die Ätzbehandlung auf einer bereits befeuchteten Oberfläche durchgeführt wird. Besonders konstante Ergebnisse lassen sich erzielen, wenn die Vorbefeuchtung der Halbleiter-Oberfläche vollflächig erfolgt, was bei einem rotierenden Wafer (zum Beispiel in einem zugehörigen Chuck) selbst bei punktueller Aufbringung der Flüssigkeit in Sekundenbruchteilen erfolgen kann.

Erst nach der Vorbefeuchtung wird eine Ätzflüssigkeit auf die Halbleiter-Oberfläche aufgetragen.

Der Ätzprozeß wird gegenüber bekannten Technologien, wie sie vorstehend beschrieben sind, wesentlich kontrollierbarer. Die Verteilung der Ätzflüssigkeit auf der befeuchteten Oberfläche erfolgt in extrem kurzer Zeit (bei Rotationsgeschwindigkeiten des Wafers von 200 bis 1.000 Umdrehungen pro Minute in weniger als 1 Sekunde) und hervorragend gleichmäßig über die gesamte Fläche. Auf der benetzten Oberfläche verteilt sich die Ätzflüssigkeit spontan und gleichmäßig. Der Benetzungsvorgang entfällt für die Ätzflüssigkeit, wenn sie auf eine bereits befeuchtete Oberfläche aufgetragen wird.

Die gleichmäßige spontane Verteilung der Ätzflüssigkeit verhindert die Bildung lokaler Zonen mit erhöhter oder reduzierter Ätzmittelmenge oder -verweildauer.

Die Zeit zum Rauhätzen kann auf weniger als 30 Sekunden, zum Teil bis auf Werte von 1 bis 10 Sekunden und damit um Zehnerpotenzen gegenüber dem Stand der Technik ( 1 bis 3 Minuten) reduziert werden.

Nach dem Ätzvorgang kann die rauh geätzte Halbleiter-Oberfläche mit einem nicht ätzenden Fluid abgespült und/oder getrocknet werden.

Während aller Verfahrensschritte soll der Halbleiter rotieren. Hierzu ist die Konfektionierung auf einem rotierenden Chuck gemäß EP 0 316 296 B1 eine gute Möglichkeit. Der Halbleiter kann dabei zwischen den Verfahrensschritten vertikal auf dem Chuck verfahren werden, wie dies in der EP 0 316 296 B1 vorgeschlagen wird.

Nach einer Ausführungsform kann die Ätzflüssigkeit unmittelbar nach Befeuchtung der Halbleiter-Oberfläche aufgetragen werden.

Beide Verfahrensschritte lassen sich in wenigen Sekunden ausführen.

Während der Befeuchtung seiner Oberfläche und/oder während des Auftragens der Ätzflüssigkeit kann der Wafer beispielsweise mit 200 bis 1.000 Umdrehungen pro Minute rotieren, wobei Umdrehungszahlen von 300 bis 500 je Minuten ausreichend erscheinen.

Nach einer Weiterbildung des Verfahrens kann der Halbleiter während der Befeuchtung seiner Oberfläche und/oder während des Auftragens der Ätzflüssigkeit mit weitestgehend konstanter Geschwindigkeit rotieren.

Nach dem Abschalten der Ätzmittel-Zufuhr kann die Rotationsgeschwindigkeit erhöht werden, um so verbleibende Ätzflüssigkeit seitlich abzuschleudern.

Die Rauhätzbehandlung kann bis zum Erreichen einer gewünschten Oberflächen-Rauhigkeit, zum Beispiel zwischen 30 und 100 nm (zwischen 300 und 1.000 Angström), durchgeführt werden.

Als Ätzflüssigkeit eignen sich Säuren und Säuremischungen, zum Beispiel aus Flußsäure, Salpetersäure, Phosphorsäure und/oder Schwefelsäure.

Die Oberfläche kann anschließend (gegebenenfalls zusätzlich) abgespült und/oder getrocknet werden.

Zum Spülen eignet sich deionisiertes Wasser. Auch kann die Halbleiter-Oberfläche vor der Ätzbehandlung mit deionisiertem Wasser befeuchtet werden. Zur Befeuchtung kann aber auch eine leichte, zum Beispiel stark verdünnte Säure, verwendet werden. Nicht geeignet ist zur Befeuchtung dagegen eine Flüssigkeit, die der eigentlichen Rauhätzung dient. Solche Rauhätzen führen zu einer Erhöhung der Rauhigkeit von mindestens 5 nm (50 Angström).

Zum Abschluß kann vorgesehen werden, die Halbleiter-Oberfläche beispielsweise mit Stickstoff oder Isopropanoldampf zu trocknen.

Nachstehend wird beispielhaft ein erfindungsgemäßes Verfahren mit seinen Schritten (einschließlich Vor- und Nacharbeiten) dargestellt:

Ein Wafer wird auf einen Chuck gesetzt und anschließend mit 500 U/min rotiert.

Deionisiertes Wasser wird auf eine Wafer-Oberfläche aufgetragen, welches sich spontan gleichmäßig verteilt und die Oberfläche entsprechend benetzt (befeuchtet).

Die Wasserzufuhr wird gestoppt. Der Wafer wird vertikal nach oben verschoben und in einer zweiten Prozeßkammer bei weiter konstanter Drehzahl wird die Ätzflüssigkeit (aus Flußsäure, Salpetersäure, Phosphorsäure und Schwefelsäure) für 2 Sekunden aufgetragen (Volumenstrom 2 l/min, Waferdurchmesser: 15 cm). Die Ätzmittelzufuhr wird sofort wieder gestoppt.

Die Rotationsgeschwindigkeit wird auf 2.500 Umdrehungen pro Minute erhöht und Rest-Ätzflüssigkeit umfangsseitig abgeschleudert.

Der Wafer wird in eine dritte Arbeitsposition im Chuck gebracht und unmittelbar danach wird deionisiertes Wasser auf die geätzte Wafer-Oberfläche kurzzeitig aufgetragen und die Oberfläche danach mit Stickstoff abgeblasen.

Die gesamte Bearbeitungszeit beträgt weniger als 30 sec.

Die erreichte Rauhigkeit beträgt 65 nm (650 Angström) und ist extrem gleichmäßig über die gesamte Wafer-Oberfläche.

## Patentansprüche

1. Verfahren zum Rauhätzen einer Halbleiter-Oberfläche mit folgenden Merkmalen:
1.1 die Halbleiter-Oberfläche wird mit einer die Halbleiter-Oberfläche nicht rauhätzenden Flüssigkeit befeuchtet,
1.2 anschließend wird eine Ätzflüssigkeit auf die feuchte Halbleiter-Oberfläche aufgetragen, wobei die Halbleiter-Oberfläche rauhgeätzt wird,
1.3 danach wird die rauh geätzte Halbleiter-Oberfläche mit einem nicht ätzenden Fluid abgespült und/oder getrocknet,
wobei der Halbleiter während aller Verfahrensschritte rotiert.

2. Verfahren nach Anspruch 1, bei dem die Ätzflüssigkeit unmittelbar nach Befeuchtung der Halbleiter-Oberfläche aufgetragen wird.

3. Verfahren nach Anspruch 1, bei dem der Halbleiter während der Befeuchtung seiner Oberfläche und/oder während des Auftragens der Ätzflüssigkeit mit 200 bis 1.000 Umdrehungen pro Minute rotiert.

4. Verfahren nach Anspruch 1, bei dem der Halbleiter während der Befeuchtung seiner Oberfläche und/oder während des Auftragens der Ätzflüssigkeit mit weitestgehend konstanter Geschwindigkeit rotiert.

5. Verfahren nach Anspruch 1, bei dem die Ätzflüssigkeit durch Erhöhung der Rotationsgeschwindigkeit des Halbleiters und vor dem anschließenden Abspülen und/oder Trocknen von der Halbleiter-Oberfläche abgeschleudert wird.

6. Verfahren nach Anspruch 1, bei dem die Rauhätzbehandlung bis zum Erreichen einer Oberflächen-Rauhigkeit zwischen 30 und 100 nm (300 und 1.000 Angström) durchgeführt wird.

7. Verfahren nach Anspruch 1, bei dem die Dauer der Ätzbehandlung der Halbleiter-Oberfläche auf weniger als 30 Sekunden bei einem Volumenstrom der Ätzflüssigkeit von 1 bis 3 l/min begrenzt wird.

8. Verfahren nach Anspruch 7, bei dem die Dauer der Ätzbehandlung der Halbleiter-Oberfläche auf weniger als 10 Sekunden bei einem Volumenstrom der Ätzflüssigkeit von 1 bis 3 l/min begrenzt wird.

9. Verfahren nach Anspruch 1, bei dem die Halbleiter-Oberfläche mit einer Ätzflüssigkeit behandelt wird, die mindestens eine der folgenden Säuren enthält: Flußsäure, Salpetersäure, Phosphorsäure und Schwefelsäure.

10. Verfahren nach Anspruch 1, bei dem die Halbleiter-Oberfläche vor der Ätzbehandlung mit deionisiertem Wasser befeuchtet wird.

11. Verfahren nach Anspruch 1, bei dem die Halbleiter-Oberfläche nach der Ätzbehandlung mit deionisiertem Wasser abgespült wird.

12. Verfahren nach Anspruch 1, bei dem die Halbleiter-Oberfläche nach der Ätzbehandlung und gegebenenfalls anschließendem Abspülen mit Stickstoff oder Isopropanoldampf getrocknet wird.

## Claims

1. Method for rough-etching of a semiconductor surface, having the following features:
1.1 the semiconductor surface is moistened with a liquid, which does not rough-etch the semiconductor surface,
1.2 an etching fluid is then applied to the moist semiconductor surface, the semiconductor surface being rough-etched,
1.3 after that, the rough-etched semiconductor surface is rinsed with a non-etching fluid and/or dried,
the semiconductor being rotated during all of the method steps.

2. Method according to claim 1, in which the etching liquid is applied directly after moistening of the semiconductor surface.

3. Method according to claim 1, in which the semiconductor is rotated during moistening of its surface and/or during application of the etching liquid at 200 to 1000 rpm.

4. Method according to claim 1, in which the semiconductor is rotated during moistening of its surface and/or during application of the etching liquid at an extensively constant speed.

5. Method according to claim 1, in which the etching liquid is thrown off by increasing the rotational speed of the semiconductor and before subsequent rinsing and/or drying of the semiconductor surface.

6. Method according to claim 1, in which the rough-etching treatment is implemented until a surface roughness of between 30 and 100 nm (300 and 1,000 Angstrom units) is achieved.

7. Method according to claim 1, in which the duration of the etching treatment of the semiconductor surface is limited to less than 30 seconds with a volume flow of etching liquid of 1 to 3 l/min.

8. Method according to claim 7, in which the duration of the etching treatment of the semiconductor surface is limited to less than 10 seconds with a volume flow of etching liquid of 1 to 3 l/min.

9. Method according to claim 1, in which the semiconductor surface is treated with an etching liquid which contains at least one of the following acids: hydrofluoric acid, nitric acid, phosphoric acid and sulphuric acid.

10. Method according to claim 1, in which the semiconductor surface is moistened with deionised water before the etching treatment.

11. Method according to claim 1, in which the semiconductor surface is rinsed with deionised water after the etching treatment.

12. Method according to claim 1, in which the semiconductor surface is dried with nitrogen or isopropanol vapour after the etching treatment and if necessary subsequent rinsing.

## Revendications

1. Procédé de décapage d'une surface d'un semi-conducteur ayant les caractéristiques suivantes :
1.1 la surface du semi-conducteur est mouillée avec un liquide non décapant,
1.2 on applique ensuite sur la surface du semi-conducteur mouillé un liquide décapant, ce qui aboutit au décapage de la surface du semi-conducteur,
1.3 la surface du semi-conducteur décapée est ensuite rincée avec un fluide non décapant et/ou est séchée,
le semi-conducteur étant en rotation pendant l'ensemble des étapes du procédé.

2. Procédé selon la revendication 1, dans lequel le liquide de décapage est appliqué immédiatement après mouillage de la surface du semi-conducteur.

3. Procédé selon la revendication 1, dans lequel le semi-conducteur tourne, pendant l'étape de mouillage de sa surface et/ou pendant l'application du liquide de décapage, à une vitesse de 200 à 1000 tours par minutes.

4. Procédé selon la revendication 1, dans lequel le semi-conducteur tourne à une vitesse sensiblement constante pendant le mouillage de sa surface et/ou pendant l'application du liquide de décapage.

5. Procédé selon la revendication 1, dans lequel le liquide de décapage est éliminé de la surface du semi-conducteur, avant l'étape de rinçage et/ou de séchage, par augmentation de la vitesse de rotation du semi-conducteur.

6. Procédé selon la revendication 1, dans lequel on poursuit le traitement décapant jusqu'à ce que l'on atteigne une rugosité de surface comprise entre 30 et 100 nm (300 et 1000 Angströms).

7. Procédé selon la revendication 1, dans lequel la durée du traitement décapant de la surface du semi-conducteur est limitée à une valeur inférieure à 30 secondes pour un débit en liquide décapant compris entre 1 et 3 l/minute.

8. Procédé selon la revendication 7, dans lequel la durée du traitement décapant de la surface du semi-conducteur est limitée à une valeur inférieure à 10 secondes pour un débit en liquide décapant compris entre 1 et 3 l/minute.

9. Procédé selon la revendication 1, dans lequel la surface du semi-conducteur est traitée avec un liquide décapant contenant au moins un des acides suivants : acide fluorhydrique, acide nitrique, acide phosphorique et acide sulfurique.

10. Procédé selon la revendication 1, dans lequel la surface du semi-conducteur est mouillée avant l'étape de décapage avec de l'eau désionisée.

11. Procédé selon la revendication 1, dans lequel la surface du semi-conducteur est rincée, après l'étape de décapage, avec de l'eau désionisée.

12. Procédé selon la revendication 1, dans lequel la surface du semi-conducteur est séchée, après l'étape de décapage suivie éventuellement du rinçage, avec de l'azote ou avec de la vapeur d'isopropanol.
